# EUROPÄISCHE PATENTANMELDUNG

(11) **EP 0 918 451 A2**
(43) Veröffentlichungstag der Anmeldung: **26.05.1999**
(21) Anmeldenummer: 98120453.0
(22) Anmeldetag: 29.10.1998
(51) Int. Cl.: H05K 5/02

(54) **Gehäuse zur Aufnahme elektrischer oder elektronischer Bauteile**

(30) Priorität: 19.11.1997 DE 29720509 U
(71) Anmelder: H.-J. Bernstein GmbH, 32479 Hille (DE)
(72) Erfinder:
(74) Vertreter: Stracke, Alexander, Dipl.-Ing.

(57) **Zusammenfassung**

Die Erfindung beschreibt ein Gehäuse zur Aufnahme elektrischer oder elektronischer Bauteile, bestehend aus einem Unterteil (1) und einem Oberteil (2) mit einem im wesentlichen rechteckigen oder quadratischen Grundriß.
Ziel der Erfindung ist die Schaffung eines derartigen Gehäuses, welches einfach und kostengünstig in der Herstellung ist und im Gebrauch einfach geöffnet und ebenso einfach vollständig verschlossen werden kann.
Zu diesem Zweck wird vorgeschlagen, daß mindestens an zwei einander gegenüberliegenden Seiten des Gehäuses Scharnier- und Verschlußteile (3) vorgesehen sind, welche sowohl in den Seitenwandungsbereich des Unterteiles (1) wie auch in den Seitenwandungsbereich des Oberteiles (2) eingeschnäppt und im Bereich der Trennebene (4) zwischen Unter- und Oberteil (1, 2) scharnierartig verschwenkbar sind.
Das Unterteil (1) und das Oberteil (2) können als relativ einfache Bauteile gestaltet werden, da keine besondere Rücksicht auf die Anbringung von Scharnieren und separaten Verschlußteilen genommen werden muß. Es ist lediglich sowohl beim Unterteil (1) wie auch beim Oberteil (2) dafür Sorge zu tragen, daß die erfindungsgemäß verwendeten Scharnier- und Verschlußteile (3) im jeweiligen Seitenwandungsbereich eingeschnäppt werden können. Hierfür genügen einfache Ausnehmungen oder Durchbrüche in den dafür vorgesehenen Seitenwandungsbereichen.

## Beschreibung

Die vorliegende Erfindung betrifft ein Gehäuse zur Aufnahme elektrischer oder elektronischer Bauteile, bestehend aus einem Unterteil und einem Oberteil mit einem im wesentlichen rechteckigen oder quadratischen Grundriß.

Der vorliegenden Erfindung liegt die Aufgabe zugrunde, ein Gehäuse der gattungsgemäßen Art so zu gestalten, daß dieses einfach und kostengünstig herstellbar und ebenfalls einfach geöffnet und vollständig verschlossen werden kann.

Diese Aufgabe wird erfindungsgemäß dadurch gelöst, daß mindestens an zwei einander gegenüberliegenden Seiten des Gehäuses Scharnier- und Verschlußteile vorgesehen sind, welche sowohl in den Seitenwandungsbereich des Unterteiles wie auch in den Seitenwandungsbereichen des Oberteiles eingeschnäppt und im Bereich der Trennebene zwischen Unter- und Oberteil scharnierartig verschwenkbar sind.

Ein derart gestaltetes Gehäuse bietet eine Reihe von praktischen Vorteilen.

So können einerseits das Unterteil und das Oberteil als relativ einfache Bauteile gestaltet werden, da keine besondere Rücksicht auf die Anbringung von Scharniern und separaten Verschlußteilen genommen werden muß. Es ist lediglich sowohl beim Unterteil wie beim Oberteil dafür zu sorgen, daß die erfindungsgemäß verwendeten Scharnier- und Verschlußteile im jeweiligen Seitenwandungsbereich eingeschnäppt werden können. Hierfür genügen einfache Ausnehmungen oder Durchbrüche in den dafür sorgesehenen Seitenwandungsbereichen.

Die Scharnier- und Verschlußteile sind ebenfalls einfach und preiswert herstellbar, einerseits schon deshalb, weil diese Scharnier- und Verschlußteile zwei Funktionen gleichzeitig übernehmen können und andererseits deshalb, weil die entsprechenden Scharnier- und Verschlußteile wiederum nur mit Mitteln auszustatten sind, die ein Einrasten oder Einschnäppen in entsprechende Gegenstücke von Unterteil und Oberteil ermöglichen.

Es werden für das erfindungsgemäße Gehäuse insbesondere keine Verschlußschrauben und insbesondere auch keine aufwendig gestalteten Scharniere benötigt. Das Gehäuse kann bei Bedarf vollständig verschlossen und bei Bedarf auch entweder im Sinne des Abklappens des Oberteiles deckelartig geöffnet oder auch vollständig demontiert werden.

Weitere Merkmale der Erfindung sind Gegenstand von Unteransprüchen.

In den beigefügten Zeichnungen sind Ausführungsbeispiele der Erfindung dargestellt, die im folgenden näher beschrieben werden.

Es zeigen:
- Figur 1: eine perspektivische Darstellung eines erfindungsgemäßen Gehäuses im geschlossenen Zustand,
- Figur 2: einen Schnitt nach der Linie II-II in Figur 1,
- Figur 2a: einen der Figur 2 entsprechenden Schnitt durch ein Gehäuse nach einem weiteren Ausführungsbeispiel der Erfindung,
- Figur 3: das in Figur 1 dargestellte Gehäuse im aufgeklappten Zustand,
- Figur 4: eine perspektivische Darstellung eines geschlossenen Gehäuses nach einem weiteren Ausführungsbeispiel der Erfindung.

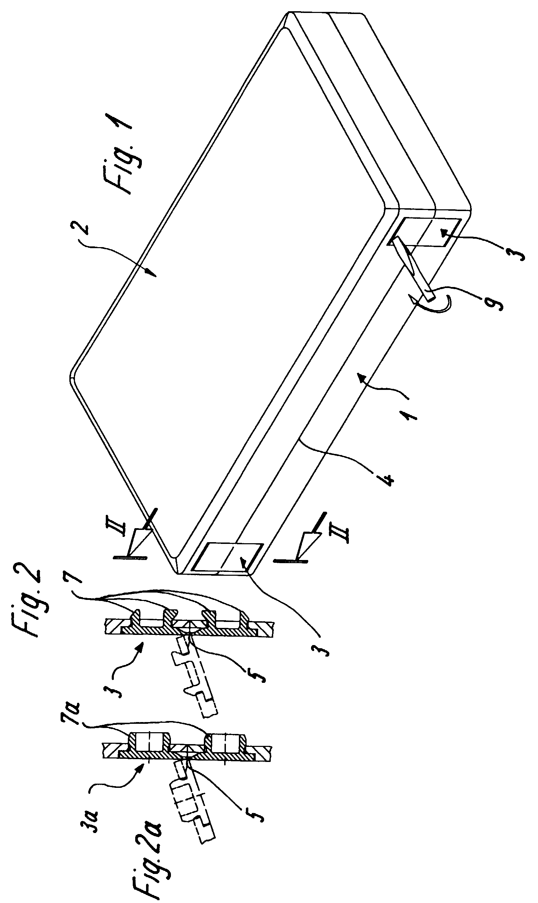

Das in den Figuren 1, 2 und 3 dargestellte Gehäuse zur Aufnahme elektrischer oder elektronischer Bauteile besteht im wesentlichen aus einem Unterteil 1 und einem Oberteil 2. Sowohl das Unterteil 1 wie auch das Oberteil 2 sind in vorteilhafter Weise einstückig aus Kunststoff gefertigt und darüber hinaus baugleich ausgeführt. Es sei allerdings an dieser Stelle schon darauf hingewiesen, daß die Höhe des Unterteiles 1 von der Höhe des Oberteiles 2 ohne weiteres auch abweichen kann.

Der Grundriß des Gehäuses ist im dargestellten Ausführungsbeispiel im wesentlichen rechteckig, selbstverständlich sind aber auch quadratische Ausführungen denkbar.

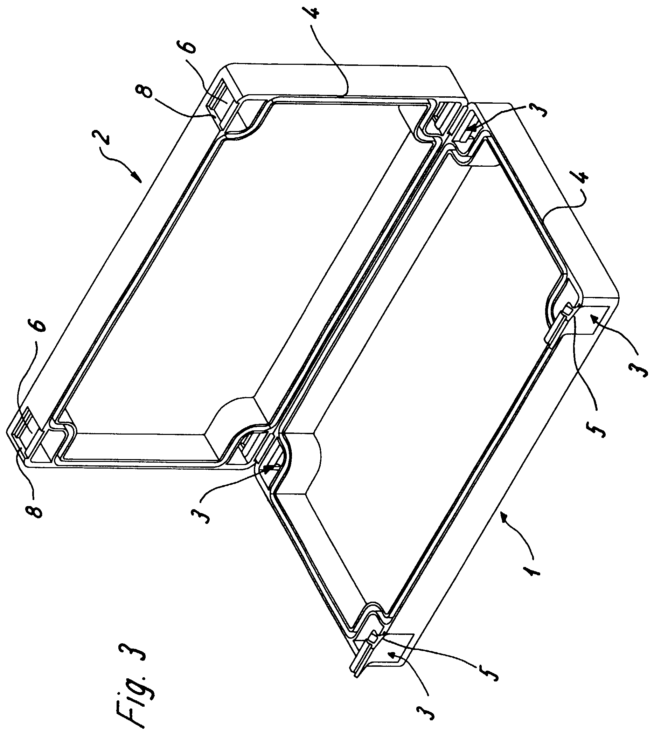

Wesentlich ist bei dem dargestellten Gehäuse, daß an mindestens zwei einander gegenüberliegenden Seiten dieses Gehäuses Scharnier- und Verschlußteile 3 vorgesehen sind, was insbesondere die Figur 3 deutlich zeigt.

Diese Scharnier- und Verschlußteile 3 sind in der Trennebene 4 zwischen Unterteil 1 und Oberteil 2 scharnierartig verschwenkbar, und zwar durch ein konstruktiv definiertes Filmscharnier 5. Jeweils symmetrisch zu dem angesprochenen Filmscharnier 5 sind die Scharnier- und Verschlußteile 3 mit Rasten versehen, die ein Einschnäppen in entsprechende Rastausnehmungen 6 des Unterteiles 1 bzw. des Oberteiles 2 ermöglichen.

Beim Ausführungsbeispiel gemäß den Figuren 1, 2 und 3 sind diese angesprochenen Rasten als parallel zum Filmscharnier 5 verlaufende Raststege 7 ausgebildet, wobei diese Konstruktion den Vorteil bietet, daß die Scharnier- und Verschlußteile aus Kunststoff, und zwar als Strangprofile hergestellt werden können.

Die Figur 2a zeigt dagegen, daß die Rasten 7a alternativ hierzu auch als druckknopfartige Rastnocken ausgebildet sein können. Es versteht sich, daß weitere Formen von Rasten denkbar sind.

Entsprechend der gewählten Form der Rasten wird der Fachmann selbstverständlich auch die Rastausnehmungen 6 im Unterteil 1 bzw. im Oberteil 2 gestalten.

Insgesamt liegen die Scharnier- und Verschlußteile 3 in der Verschlußstellung bündig innerhalb von Einsenkungen 8 des Unterteiles 1 bzw. des Oberteiles 2, so daß die Scharnier- und Verschlußteile nicht über die Seitenwandungen des Gehäuses hinaus vorstehen.

Die Scharnier- und Verschlußteile 3 bzw. 3a erfüllen somit gleich zwei Funktionen. Zum einen dienen diese Scharnier- und Verschlußteile 3 zur sicheren, schließenden Verbindung von Unterteil 1 und Oberteil 2, wobei diese Verbindung durch einfaches Eindrücken der Rasten in die Rastausnehmungen erfolgt. Beispielsweise durch einen in Figur 1 angedeuteten Schraubendreher 9 können nun die Scharnier- und Verschlußteile 3 beispielsweise auf einer Seite des Gehäuses in eine Öffnungsstellung gebracht werden, während die auf der gegenüberliegenden Seite angeordneten Scharnier- und Verschlußteile in ihrer beidseitig eingerasteten Position verbleiben. Dann besteht die Möglichkeit, das Oberteil 2 wie einen Deckel gegenüber dem Unterteil 1 aufzuschwenken, was in Figur 3 andeutungsweise gezeigt ist. Bei entsprechender Elastizität der Filmscharniere 5 kann das Oberteil 2 gegenüber dem Unterteil 1 bis in eine Parallellage verschwenkt werden. Bei Bedarf können aber auch Unterteil 1 und Oberteil 2 vollständig voneinander getrennt werden, es ist dann lediglich erforderlich, alle verwendeten Scharnier- und Verschlußteile entsprechend zu lösen.

Bei dem Ausführungsbeispiel gemäß den Figuren 1-3 sind an zwei gegenüberliegen-den Seiten des Gehäuses jeweils zwei Scharnier- und Verschlußteile eingesetzt.

Hiervon sind selbstverständlich Abweichungen denkbar.

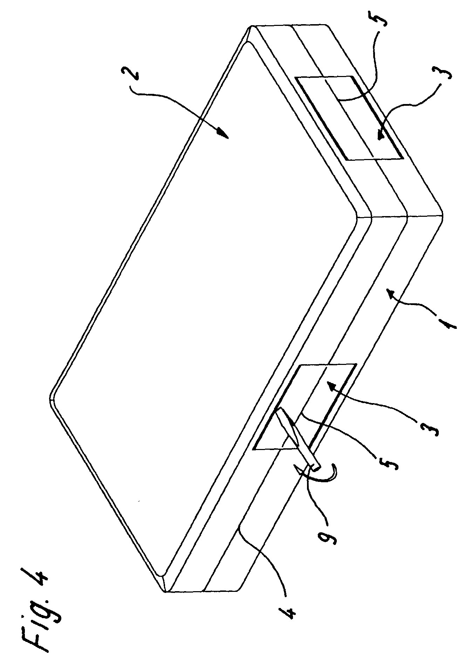

So zeigt beispielsweise die Figur 4, daß an zwei gegenüberliegenden Seiten auch lediglich jeweils ein Scharnier- und Verschlußteil 3 vorgesehen sein kann, wobei es dann empfehlenswert ist, die Länge dieses Scharnier- und Verschlußteiles 3 so zu wählen, daß eine zuverlässige Scharnierfunktion gegeben ist, wenn das Oberteil 2 gelenkartig mit dem Unterteil 1 verbunden bleiben soll während eines Öffnungsvorganges. Figur 4 zeigt darüber hinaus, daß zusätzlich auch an den benachbarten Stirnseiten Scharnier- und Verschlußteile 3 vorgesehen werden können, wodurch bei entsprechend großen Gehäusen der Schließzustand zusätzlich sicherer gestaltet wird.

Ebenso ist es denkbar, bei einer Ausführungsform wie sie in Figur 1 gezeigt ist, zwischen den beiden im äußeren Eckbereich angeordneten Scharnier- und Verschlußteilen 3 etwa in der Mitte ein zustätzliches Scharnier- und Verschlußteil 3 anzuordnen, ebenfalls aus Gründen der Stabilitätserhöhung sowohl beim Schließzustand wie auch beim scharnierartigen Öffnungsvorgang. Es wurde schon darauf hingewiesen, daß die Scharnier- und Verschlußteile 3 zum Filmscharnier 5 symmetrisch asusgebildet sind, so daß der Vorteil erreicht ist, daß beim Einschnäppen der Scharnier- und Verschlußteile in die Rastausnehmungen 6 von Unterteil 1 und Oberteil 2 keine Rücksicht auf die Lage der Scharnier- und Verschlußteile 3 bzw. 3a genommen werden muß.

Insgesamt besteht das erfindungsgemäße Gehäuse aus äußerst einfach und preiswert herstellbaren Kunststoffteilen und ist - ohne funktionelle Beeinträchtigung - leicht und schnell in einen geschlossenen Zustand zu bringen und ebenso leicht und schnell auch ganz oder teilweise zu öffnen.

## Patentansprüche

1. Gehäuse zur Aufnahnme elektrischer oder elektronischer Bauteile, bestehend aus einem Unterteil und einem Oberteil mit einem im wesentlichen rechteckigen oder quadratischen Grundriß, **dadurch gekennzeichnet, daß** mindestens an zwei einander gegenüberliegenden Seiten des Gehäuses Scharnier- und Verschlußteile (3) vorgesehen sind, welche sowohl in den Seitenwandungsbereich des Unterteiles (1) wie auch in den Seitenwandungsbereich des Oberteiles (2) eingeschnäppt und im Bereich der Trennebene (4) zwischen Unter-und Oberteil (1, 2) scharnierartig verschwenkbar sind.

2. Gehäuse nach Anspruch 1, **dadurch gekennzeichnet, daß** an zwei gegenüberliegenden Seiten des Gehäuses jeweils ein Scharnier- und Verschlußteil (3) angebracht ist.

3. Gehäuse nach Anspruch 1, **dadurch gekennzeichnet, daß** an zwei gegenüberliegenden Seiten des Gehäuses jeweils zwei oder mehrere Scharnier- und Verschlußteile (3) angebracht sind.

4. Gehäuse nach Anspruch 1, **dadurch gekennzeichnet, daß** an allen Seiten des Gehäuses mindestens jeweils ein Scharnier- und Verschlußteil (3) angebracht ist.

5. Gehäuse nach einem oder mehreren der vorhergehenden Ansprüche, **dadurch gekennzeichnet, daß** die Scharnier- und Verschlußteile (3) jeweils einstückig aus Kunststoff hergestellt und mit einem Filmscharnier (59 ausgestattet sind.

6. Gehäuse nach Anspruch 5, **dadurch gekennzeichnet, daß** die Scharnierund Verschlußteile jeweils zu beiden Seiten des Filmscharnieres mit Rasten versehen sind, die in entsprechende Rastausnehmungen (6) innerhalb der Seitenwandungsbereiche von Unterteil (1) und Oberteil (2) eingeschnäppt sind.

7. Gehäuse nach Anspruch 6, **dadurch gekennzeichnet, daß** die Rasten aus Raststegen (7) bestehen, welche parallel zum Filmscharnier (5) verlaufen.

8. Gehäuse nach Anspruch 7, **dadurch gekennzeichnet, daß** die Raststege (7) jeweils symmetrisch zum Filmscharnier angeordnet sind.

9. Gehäuse nach Anspruch 6, **dadurch gekennzeichnet, daß** die Rasten aus symmetrisch zum Filmscharnier angeordneten, druckknopfartigen Rastnocken (7a) bestehen.

10. Gehäuse nach einem oder mehreren der vorhergehenden Ansprüche, **dadurch gekennzeichnet, daß** das Unterteil (1) und das Oberteil (2) aus baugleichen Teilen bestehen und aus Kunststoff gefertigt sind.

11. Gehäuse nach einem oder mehreren der vorhergehenden Ansprüche, **dadurch gekennzeichnet, daß** die Scharnier- und Verschlußteile (3) im Verschlußzustand bündig innerhalb von Einsenkungen (8) des Unterteiles (1) und des Oberteiles (2) liegen.
